# EUROPEAN PATENT APPLICATION

(11) **EP 4 050 664 A1**
(43) Date of publication of application: **31.08.2022**
(21) Application number: 20879294.5
(22) Date of filing: 14.10.2020
(51) Int. Cl.: H01L 31/048, H01L 31/049

(54) **SOLAR CELL MODULE**

(30) Priority: 21.10.2019 JP 2019191992
(71) Applicant: Toyo Aluminium Kabushiki Kaisha, Osaka-shi, Osaka 541-0056 (JP)
(72) Inventor: FUJINO, Takaaki, Osaka-shi, Osaka 541-0056 (JP); MAEDA, Daisuke, Osaka-shi, Osaka 541-0056 (JP); MORI, Keita, Osaka-shi, Osaka 541-0056 (JP)
(74) Representative: Marks & Clerk LLP
(86) International application number: PCT/JP2020/038821
(87) International publication number: WO 2021/079807

(57) **Abstract**

The present invention provides a solar cell module having reduced cell cracking even when a thin surface glass layer is used, reduced remaining bubbles after vacuum lamination, and reduced delamination between the second sealing layer and the back protective layer after DH, as well as excellent load-bearing properties. Specifically, the present invention provides a solar cell module comprising, in sequence from a light-receiving surface side, a surface glass layer having a thickness of 0.4 mm or more and 1.6 mm or less, a first sealing layer, cells, a second sealing layer, and a back protective layer, wherein the back protective layer comprises, in sequence from a side closer to the second sealing layer, a first easy-adhesion resin layer having adhesiveness to the second sealing layer, a second resin sheet layer having a flexural modulus of 1500 MPa or more and 4000 MPa or less, a third resin layer being in a foam state and having a flexural modulus of 200 MPa or more and 1000 MPa or less, and a fourth resin layer having a flexural modulus of 10000 MPa or more and 45000 MPa or less.

## Description

### Technical Field

The present invention relates to a solar cell module.

### Background Art

Solar cell modules usually have a structure in which a surface glass layer having a thickness of about 2.0 to 3.2 mm, a sealing material, crystalline silicon solar cells, a sealing material, and a back protective sheet are layered in sequence.

Since these crystalline solar cell modules have a weight of about 18 kg (= 11 kg/m²) per sheet, there can be restrictions on the installation thereof. For example, it is difficult for a solo operator to install modules in a high place; and due to load-bearing restrictions, solar cell modules sometimes cannot be laid over the surface of the roof of a simple structure, such as a carport.

Under these circumstances, in order to reduce the weight of solar cell modules, as a solar cell module that reduces cell cracking even when a thin surface glass layer is used, Patent Literature 1 suggests a solar cell module comprising, in sequence from a light-receiving surface side, a glass layer having a thickness of 0.8 mm or more and 1.6 mm or less, a first sealing layer, cells, a second sealing layer, and a back protective layer, wherein the back protective layer comprises, in sequence from a side in contact with the second sealing layer, a first resin layer being in a foam state and having a flexural modulus of 200 MPa or more and 1000 MPa or less, and a second resin layer containing glass fiber and having a flexural modulus of 10000 MPa or more and 25000 MPa or less; and
the sum of flexural rigidity of the glass layer, the first sealing layer, the second sealing layer, and the back protective layer defined by {(flexural modulus (MPa) × thickness (mm)³)/12} is 4000 MPa·mm³ or more.

### Citation List

### Patent Literature

PTL 1: WO2019/059072

### Summary of Invention

### Technical Problem

However, with the technology disclosed in Patent Literature 1, during the vacuum lamination process in the production of solar cell modules, air between the first sealing layer and the second sealing layer is not released completely, and air bubbles remain at the ends of the glass layer or between cells, which may reduce the product yield.

In addition, after a dump heat (hereinafter referred to as DH) test at a temperature of 85°C and a humidity of 85%, delamination of the back protective layer occurs at the interface between the first resin layer in a foam state and the second sealing layer, and the test load (load-bearing properties) may be reduced in a load test, which is a reliability test of solar cell modules designed for use under strong wind pressure or substantial snowfall.

The present invention improves the problems of the conventional technology, and aims to provide a solar cell module attaining reduced cell cracking even when a thin surface glass layer is used, reduced remaining bubbles after vacuum lamination, and reduced delamination between the second sealing layer and the back protective layer after DH, as well as excellent load-bearing properties.

### Solution to Problem

To attain the above object, the present inventors conducted extensive research. As a result, the present inventors found that a solar cell module with a specific layer structure can achieve the above object, and accomplished the present invention.

More specifically, the present invention relates to the following solar cell module.
1. A solar cell module comprising, in sequence from a light-receiving surface side, a surface glass layer having a thickness of 0.4 mm or more and 1.6 mm or less, a first sealing layer, cells, a second sealing layer, and a back protective layer, wherein
   the back protective layer comprises, in sequence from a side closer to the second sealing layer,
   a first easy-adhesion resin layer having adhesiveness to the second sealing layer,
   a second resin sheet layer having a flexural modulus of 1500 MPa or more and 4000 MPa or less,
   a third resin layer being in a foam state and having a flexural modulus of 200 MPa or more and 1000 MPa or less, and
   a fiber-reinforced fourth resin layer having a flexural modulus of 10000 MPa or more and 45000 MPa or less.
2. The solar cell module according to Item 1, further comprising a fifth resin sheet layer having a flexural modulus of 1500 MPa or more and 4000 MPa or less on one surface side of the fourth resin layer, the surface side being opposite to a surface side on which the third resin layer is positioned.
3. The solar cell module according to Item 1 or 2, wherein the first easy-adhesion resin layer comprises one or more resins selected from the group consisting of polyethylene resins, polypropylene resins, polystyrene resins, polyurethane resins, polybutene resins, polymethyl methacrylate resins, polyvinyl chloride resins, polyvinyl acetate resins, and polyvinyl alcohol resins, or a copolymer containing the one or more resins.
4. The solar cell module according to any one of Items 1 to 3, wherein the second resin sheet layer comprises one or more resins selected from the group consisting of polyvinyl chloride resins, polycarbonate resins, polymethyl methacrylate resins, polyethylene terephthalate resins, polybutylene terephthalate resins, polyethylene naphthalate resins, polyacetal resins, polyamide resins, and polyphenylene ether resins.
5. The solar cell module according to any one of Items 1 to 4, wherein the third resin layer comprises a foam body of one or more resins selected from the group consisting of polyethylene resins, polypropylene resins, polyamide resins, polystyrene resins, polyurethane resins, polyvinyl chloride resins, polycarbonate resins, polymethyl methacrylate resins, polyethylene terephthalate resins, polybutylene terephthalate resins, acrylonitrile styrene resins, acrylonitrile butadiene styrene resins, polyacetal resins, polyphenylene sulfide resins, polyethersulfone resins, polyether ether ketone resins, epoxy resins, vinyl ester resins, polyimide resins, unsaturated polyester resins, phenol resins, urea resins, melamine resins, and fluororesins.
6. The solar cell module according to any of Items 1 to 5, wherein the fourth resin layer comprises a fiber-reinforced resin in which glass fiber is mixed with one or more resins selected from the group consisting of polyethylene resins, polypropylene resins, polyamide resins, polystyrene resins, polyurethane resins, polyvinyl chloride resins, polycarbonate resins, polymethyl methacrylate resins, polyethylene terephthalate resins, polybutylene terephthalate resins, acrylonitrile styrene resins, acrylonitrile butadiene styrene resins, polyacetal resins, polyphenylene sulfide resins, polyethersulfone resins, polyether ether ketone resins, epoxy resins, vinyl ester resins, polyimide resins, unsaturated polyester resins, phenol resins, urea resins, melamine resins, and fluororesins.
7. The solar cell module according to any one of Items 1 to 6, wherein the third resin layer has a thickness of 2 mm or more and 6 mm or less, and a density of 100 kg/m³ or more and 700 kg/m³ or less.
8. The solar cell module according to Item 6 or 7, wherein the fourth resin layer has a thickness of 0.5 mm or more and 2.0 mm or less, and a glass fiber content of 30 wt% or more and 70 wt% or less.

### Advantageous Effects of Invention

According to the solar cell module of the present invention, a solar cell module attaining reduced cell cracking even when a thin surface glass layer is used, reduced remaining bubbles after vacuum lamination, and reduced delamination between the second sealing layer and the back protective layer after DH, as well as excellent load-bearing properties, can be provided.

### Brief Description of Drawings

Fig. 1 is a cross-sectional view schematically illustrating one embodiment of the solar cell module according to the present invention.

Fig. 2 is a cross-sectional view schematically illustrating one embodiment of the solar cell module according to the present invention.

### Description of Embodiments

The solar cell module of the present invention comprises, in sequence from a light-receiving surface side, a surface glass layer having a thickness of 0.4 mm or more and 1.6 mm or less, a first sealing layer, cells, a second sealing layer, and a back protective layer,

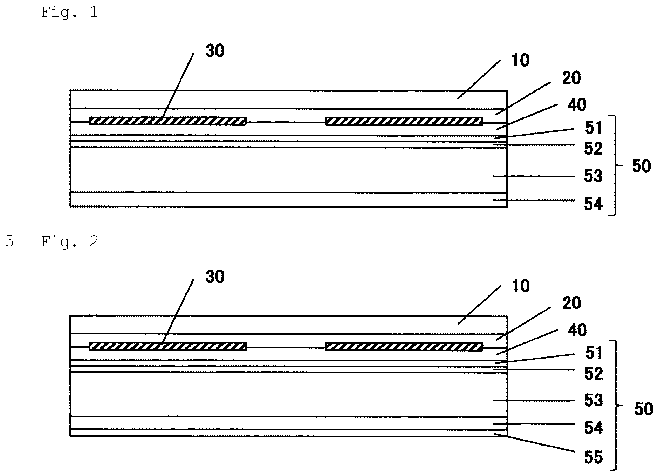

As shown in Fig. 1 as an embodiment of the present invention, the solar cell module of the present invention comprises, in sequence from the light-receiving surface side, a surface glass layer 10, a first sealing layer 20, cells 30, a second sealing layer 40, and a back protective layer 50.

The back protective layer 50 comprises, in sequence from the side that is in contact with the second sealing layer 40, a first easy-adhesion resin layer 51, a second resin sheet layer 52, a third resin layer 53, and a fourth resin layer 54, which will be described below.

As shown in Fig. 2 as an embodiment of the present invention, the solar cell module of the present invention comprises, in sequence from the light-receiving surface side, a surface glass layer 10, a first sealing layer 20, cells 30, a second sealing layer 40, and a back protective layer 50.

The back protective layer 50 comprises, in sequence from the side that is in contact with the second sealing layer 40, a first easy-adhesion resin layer 51, a second resin sheet layer 52, a third resin layer 53, a fourth resin layer 54, and a fifth resin sheet layer 55, which will be described below.

In the present specification, for example, the side on which the surface glass layer 10 is positioned with respect to the cells 30 (i.e., the light-receiving surface side (sunlight incident side)) is sometimes also referred to as "top side" or "front side"; and the side on which the back protective layer 50 is positioned with respect to the cells 30 is sometimes also referred to as "bottom side" or "back side." In this specification, the range indicated by A to B means "A or more and B or less" unless otherwise specified.

The constituent features are described below in detail.

### Surface Glass Layer 10

In the present invention, the surface glass layer has a thickness of 0.4 mm or more and 1.6 mm or less (preferably 0.5 mm or more and 1.2 mm or less). The glass plate used for general solar cell modules has a thickness of about 3.2 mm or more and 4.2 mm or less. By using a surface glass layer having a thickness that is less than half of this thickness, significant weight reduction is possible compared to general solar cells.

Although the type of glass used for the surface glass layer is not particularly limited, physical toughened glass or chemical toughened glass is preferable. If the thickness of the surface glass layer is less than 0.4 mm, the glass may be broken in a hail test. Further, if the thickness of the surface glass layer exceeds 1.6 mm, the weight of the solar cell module when produced is increased, and exceeds a weight that is usually considered to be possible for a woman to work with on her own (body weight 55 kg × 60% × 40% ≈ 13 kg); thus, the installation may be restricted in the same manner as with general solar cell modules.

The surface glass layer used in the present invention preferably has a flexural rigidity defined by {(flexural modulus (MPa) × thickness (mm)³)/12} of 300 MPa·mm³ or more and 21000 MPa· mm³ or less. By setting the flexural rigidity within this range, in particular, effects of preventing the cracking of glass in a load test or reducing the amount of deflection displacement of the module can be easily obtained.

### Sealing Layers 20 and 40

In the present invention, the sealing layers sandwich the front and back surfaces of the cells. The material used for the sealing layers is not particularly limited. Any sealing material usually used for sealing cells can be used. In particular, EVA (ethylene-vinyl acetate copolymer) or a polyolefin-based sealing material is preferable. Known additives may be appropriately added to the sealing layers to improve transparency, flexibility, adhesiveness, tensile strength, weatherability, and the like.

In the present invention, the first sealing layer is on the light-receiving surface side of the cells, while the second sealing layer is on the back surface side of the cells. However, both of these layers usually have substantially the same composition. When the cells are sealed, the first sealing layer and the second sealing layer are fused around the cells. Therefore, in the present invention, the first sealing layer and the second sealing layer are not necessarily clearly distinguished from each other, and can be regarded as a single sealing layer comprising cells inside.

The sealing layer preferably has a flexural rigidity defined by {(flexural modulus (MPa) × thickness (mm)³)/12} of 1 MPa·mm³ or more and 10 MPa·mm³ or less, and more preferably 5 MPa· mm³ or more and 10 MPa·mm³ or less.

In the present specification, the flexural rigidity of the sealing layers refers to the flexural rigidity of a single sealing layer obtained after the first sealing layer and the second sealing layer are fused with each other. The cells present in the single sealing layer do not affect the flexural rigidity of the single sealing layer. By setting the flexural rigidity within the above range, in particular, the sealing layer attains excellent flexibility and cell cracking against deflection in a load test can be prevented.

### Cell 30

In the present invention, the cell is a semiconductor that converts the energy of light directly into electricity by the photovoltaic effect.

The type of the cell is not particularly limited, and the cell used may comprise a known semiconductor, such as a silicon (Si) semiconductor; a CIS compound semiconductor comprising copper (Cu), indium (In), and selenium (Se) as starting materials; a CIGS compound semiconductor comprising copper (Cu), indium (In), selenium (Se), and gallium (Ga) as starting materials; a compound semiconductor comprising cadmium (Cd) and tellurium (Te) as starting materials; and a GaAs compound semiconductor comprising gallium (Ga) and arsenic (As) as starting materials.

The cell may further comprise, on the surface or end face thereof, a known wiring or electrode for drawing electricity (interconnector, bus bar, etc.).

### Back Protective Layer 50

In the present invention, the back protective layer is provided on the side opposite to the light-receiving surface side with respect to the cells, and comprises, in sequence from a side closer to the second sealing layer, a first easy-adhesion resin layer having adhesiveness to the second sealing layer, a second resin sheet layer having a flexural modulus of 1500 MPa or more and 4000 MPa or less, a third resin layer being in a foam state and having a flexural modulus of 200 MPa or more and 1000 MPa or less, and a fiber-reinforced fourth resin layer having a flexural modulus of 10000 MPa or more and 45000 MPa or less. A fifth resin sheet layer having a flexural modulus of 1500 MPa or more and 4000 MPa or less may be further provided on the bottom side of the fourth resin layer. The flexural modulus of the (entire) back protective layer 50 is not limited, and is preferably 500 MPa or more and 2000 MPa or less. By setting the range of flexural modulus within this range, in particular, effects of reducing the amount of deflection displacement of the module in a load test can be easily obtained.

In general solar cells, a layer called a back protective sheet (back sheet) is provided on the back surface of the solar cells; usually, a laminate of sheets of polyethylene terephthalate (PET), low-density polyethylene, vinylidene fluoride, etc. is used. However, if a thin surface glass layer is used with a conventional back protective sheet as the back protective layer in a solar cell module, the rigidity of the solar cell module will be deteriorated, and cell cracking will occur during transportation or installation. On the other hand, the use of the back protective layer having the structure of the present invention on the back surface of the solar cells can increase the rigidity of the solar cell module comprising a thin surface glass layer.

In addition to the first easy-adhesion resin layer, the second resin sheet layer, the third resin layer, the fourth resin layer, and the fifth resin sheet layer described above, the back protective layer may appropriately comprises other layer(s) between layers or at the bottom to improve water resistance, power generation efficiency, and voltage resistance. For example, the back protective layer may comprise one or two or more layers selected from the group consisting of adhesive layers and weather-resistant layers at at least one position selected from: between the first easy-adhesion resin layer and the second resin sheet layer, between the second resin sheet layer and the third resin layer, between the third resin layer and the fourth resin layer, between the fourth resin layer and the fifth resin sheet layer, and on the surface (bottom layer) of the fifth resin sheet layer opposite to the surface on which the fourth resin layer is laminated.

The constituent features of the back protective layer are detailed below.

### First Easy-Adhesion Resin Layer 51

In the present invention, the first easy-adhesion resin layer of the back protective layer is a layer that is closer to the second sealing layer described above, and has adhesiveness to the second sealing layer. Preferably, the first easy-adhesion resin layer exhibits adhesiveness to the second sealing layer by thermal melting adhesion in vacuum lamination at 130°C or more and 160°C or less.

The type of the resin in the first easy-adhesion resin layer is not particularly limited. Preferable examples include one or more resins selected from the group consisting of polyethylene resins, polypropylene resins, polystyrene resins, polyurethane resins, polybutene resins, polymethyl methacrylate resins, polyvinyl chloride resins, polyvinyl acetate resins, and polyvinyl alcohol resins, or a copolymer containing the one or more resins. The first easy-adhesion resin layer can be prepared in the form of a film, sheet, or coating containing the resin or copolymer in the production process of the solar cell module. These films or sheets may be stretched uniaxially or biaxially.

Of these, polyethylene resins (high-density polyethylene, low-density polyethylene, and linear low-density polyethylene) are preferable, and linear low-density polyethylene is more preferable because excellent adhesiveness to EVA, which is a general sealing material of the solar cell module, can be ensured. Linear low-density polyethylene (LLDPE), which has a higher density than low-density polyethylene (LDPE), is preferable for its excellent heat resistance and weatherability.

For the film-forming method, T-die molding or inflation molding is used. Molding with a multilayer extruder is also possible. Further, the resin layer can be appropriately colored white, black, or the like. Examples of the coloring means include coating, film formation by pigment kneading, and the like.

The thickness of the first easy-adhesion resin layer is preferably 3 µm or more and 150 µm or less, and particularly preferably 6 µm or more and 70 µm or less.

### Second Resin Sheet Layer 52

In the present invention, the second resin sheet layer of the back protective layer is a layer positioned on a side that is not in contact with the second sealing layer of the first easy-adhesion resin layer, i.e., a layer on the side opposite to the light-receiving surface side. The second resin sheet layer is composed of a resin sheet layer having a flexural modulus of 1500 MPa or more and 4000 MPa or less.

The type of the resin in the second resin sheet layer is not particularly limited as long as the second resin sheet layer is a film or sheet having a flexural modulus within the above range. Preferable examples include polyvinyl chloride resins, polycarbonate resins, polymethyl methacrylate resins, polyethylene terephthalate resins, polybutylene terephthalate resins, polyethylene naphthalate resins, polyacetal resins, polyamide resins, and polyphenylene ether resins. The second resin sheet can be prepared in the form of a film or sheet containing the resin in the production process of the solar cell module. These resin films or sheets may be stretched uniaxially or biaxially.

Of these, a polyester resin (at least one of polyethylene terephthalate resin and polybutylene terephthalate resin) is preferable because electrical insulation, handling properties, and the like can be ensured. Further, the resin layer can be appropriately colored white, black, or the like. Examples of the coloring means include coating, film formation by pigment kneading, and the like.

For the film-forming method, T-die molding or inflation molding is used. Molding with a multilayer extruder is also possible.

The second resin sheet layer has a flexural modulus of 1500 MPa or more and 4000 MPa or less, and preferably 2000 MPa or more and 3500 MPa or less. If the flexural modulus is less than 1500 MPa, required rigidity cannot be obtained. If the flexural modulus exceeds 4000 MPa, problems such that flexibility cannot be obtained and the adhesive has poor coating property, or the sheet easily cracks occur.

The thickness of the second resin sheet layer is preferably 0.03 mm or more and 0.5 mm or less, and more preferably 0.05 mm or more and 0.3 mm or less. If the thickness of the second resin sheet layer is less than 0.03 the required rigidity may not be obtained. If the thickness of the second resin sheet layer exceeds 0.5 it is not possible to roll up the sheet, which may impair handling properties.

### Third Resin Layer 53

In the present invention, the third resin layer of the back protective layer is a layer positioned on a side of the second resin sheet layer opposite to the surface on which the first easy-adhesion resin layer is laminated, i.e., a layer on the side opposite to the light-receiving surface side. The third resin layer is composed of a resin layer in a foam state having a flexural modulus of 200 MPa or more and 1000 MPa or less.

The type of the resin in the third resin layer is not particularly limited as long as the third resin layer is a foam body having a flexural modulus within the above range. The third resin layer preferably comprises a foam body of one or more resins selected from the group consisting of polyethylene resins, polypropylene resins, polyamide resins,_polystyrene resins, polyurethane resins, polyvinyl chloride resins, polycarbonate resins, polymethylmethacrylate resins, polyethylene terephthalate resins, polybutylene terephthalate resins, acrylonitrile styrene resins, acrylonitrile butadiene styrene resins, polyacetal resins, polyphenylene sulfide resins, polyethersulfone resins, polyether ether ketone (PEEK) resins, epoxy resins, vinyl ester resins, polyimide resins, unsaturated polyester resins, phenol resins, urea resins, melamine resins, and fluororesins. In general, the foam body thereof may be used. Of these resins, polypropylene or epoxy resins are particularly preferable in view of strength, heat resistance, and weatherability.

The third resin layer has a flexural modulus of 200 MPa or more and 1000 MPa or less, and preferably 300 MPa or more and 800 MPa or less. If the flexural modulus is less than 200 MPa, the required rigidity cannot be obtained. If the flexural modulus exceeds 1000 MPa, warping is increased in vacuum lamination, and the weight is increased due to the increase in flexural modulus. Thus, a flexural modulus exceeding 1000 MPa is not preferable.

The third resin layer is a foam body of the above resin, and preferably has a thickness of 2 mm or more and 6 mm or less, and more preferably 3 mm or more and 5 mm or less. If the thickness of the third resin layer is less than 2 rigidity cannot be obtained and cell cracking may occur. If the thickness of the third resin layer exceeds 6 heat will not be able to escape in vacuum lamination for producing the solar cell module, generating residual thermal stress, which may cause warping of the solar cell module.

The third resin layer preferably has a density of 100 kg/m³ or more and 700 kg/m³ or less. If the density of the third resin layer exceeds 700 kg/m³, the layer becomes hard and heavy, and heat does not easily escape during vacuum lamination in the production of the solar cell module, which generates residual thermal stress, possibly causing warping of the solar cell module. Furthermore, if the density of the third resin layer is less than 100 kg/m³, the layer becomes too soft, and cracking may occur due to the bending load in a load test; further, foams of the foam body may be broken by hot-pressing at about 150°C in vacuum lamination in the production of the solar cell module.

The third resin layer preferably has a flexural rigidity defined by {(flexural modulus (MPa) × thickness (mm)³)/12} of 100 MPa·mm³ or more and 20000 MPa·mm³ or less. By setting the flexural modulus within this range, in particular, effects of reducing the amount of deflection displacement of the module in a load test can be easily obtained.

The method for obtaining the third resin layer in a foam state is not limited. For example, a known physical foaming method or chemical foaming method can be used. From the viewpoint of regulating foam particles, a chemical foaming method is preferable. Further, to obtain the third resin layer in a foam state, the foaming ratio is preferably 1.5-fold or more and 8-fold or less, and particularly preferably 2-fold or more and less than 5-fold.

If the foaming ratio is less than 1.5-fold, the density exceeds 700 kg/m³ or more, and warping may occur in the solar cell module in the vacuum lamination as described above. If the foaming ratio is greater than 8-fold, the density becomes less than 100 kg/m³, and cracking may occur due to the bending load in a load test; further, foams of the foam body may be broken in vacuum lamination.

### Fourth Resin Layer 54

In the present invention, the fourth resin layer of the back protective layer is a layer positioned on a side opposite to the surface of the third resin layer on which the second resin sheet layer is laminated, i.e., a layer on the side opposite to the light-receiving surface side. The fourth resin layer is composed of a fiber-reinforced resin layer having a flexural modulus of 10000 MPa or more and 45000 MPa or less.

The type of the resin in the fourth resin layer is not particularly limited as long as the fourth resin layer is a fiber-reinforced resin layer having a flexural modulus within the above range. From the viewpoint of strength, heat resistance, and weatherability, preferable examples include a fiber-reinforced resin in which glass fiber is mixed with one or more resins selected from the group consisting of polyethylene resins, polypropylene resins, polyamide resins, polystyrene resins, polyurethane resins, polyvinyl chloride resins, polycarbonate resins, polymethyl methacrylate resins, polyethylene terephthalate resins, polybutylene terephthalate resins, acrylonitrile styrene resins, acrylonitrile butadiene styrene resins, polyacetal resins, polyphenylene sulfide resins, polyethersulfone resins, polyether ether ketone resins, epoxy resins, vinyl ester resins, polyimide resins, unsaturated polyester resins, phenol resins, urea resins, melamine resins, and fluororesins. Of these resins, polypropylene or epoxy resins are particularly preferable in view of strength, heat resistance, and weatherability.

The fiber contained in the fiber-reinforced resin layer is preferably glass fiber because it has high fire resistance and dimensional stability, and can suppress deformation against temperature change, thus improving the fire resistance and dimensional stability of the module. The resin containing glass fiber is also called glass fiber-reinforced resin (also referred to as "glass FRP," or simply "FRP"), and is obtained by infiltrating fine glass fiber with the resin while maintaining the fiber directionality. The type of glass contained in the fourth resin layer is not particularly limited. For example, a known glass fiber in the form of roving cloth, glass fiber in the form of mat, and the like can be used. From the viewpoint of strength and surface accuracy, plain-woven glass cloth is preferable.

The ratio of the glass fiber to the resin is not particularly limited. For example, glass fiber having an average thickness of 1 µm or more and 10 µm or less, and an average length of 1 mm or more and 20 mm or less is preferably contained in an amount of 30 wt% or more and 70 wt% or less in 100 wt% of the fourth resin layer.

The fourth resin layer has a flexural modulus of 10000 MPa or more and 45000 MPa or less, and preferably 15000 MPa or more and 35000 MPa or less. If the flexural modulus is less than 10000 MPa, the required rigidity cannot be obtained, which may cause warping of the module after vacuum lamination. If the flexural modulus exceeds 45000 MPa, the weight increases.

The fourth resin layer is a mixture comprising glass fiber and the above resin, and preferably has a thickness of 0.5 mm or more and 2.0 mm or less, and more preferably 0.5 mm or more and 1.0 mm or less. If the thickness of the fourth resin layer is less than 0.5 rigidity cannot be obtained, and cell cracking may occur. If the thickness of the fourth resin layer exceeds 2.0 the adhesion surface may be lifted due to overly high rigidity when adhering to other layers.

The fourth resin layer preferably has a density of 1500 kg/m³ or more and 2500 kg/m³ or less. If the density of the fourth resin layer is less than 1500 kg/m³, the strength is likely to be insufficient because such a density is the same as that of normal resins. If the density exceeds 2500 kg/m³, the weight is likely to be excessive because such a density is the same as that of glass.

The fourth resin layer preferably has a flexural rigidity defined by {(flexural modulus (MPa) × thickness (mm)³)/12} of 100 MPa·mm³ or more and 20000 MPa·mm³ or less. By setting the flexural rigidity within this range, in particular, effects of reducing the amount of deflection displacement of the module in a load test can be easily obtained.

The method for forming the fourth resin layer is not particularly limited, and a known resin extrusion method or resin liquid impregnation method can be used.

### Fifth Resin Sheet Layer 55

In the present invention, the fifth resin sheet layer of the back protective layer is an optional layer that is provided as necessary on a side of the fourth resin layer opposite to the side on which the third resin layer is laminated, i.e., on the side opposite to the light-receiving surface side (i.e., one surface side of the fourth resin layer, the surface side being opposite to the surface side on which the third resin layer is positioned). The fifth resin sheet layer is preferably composed of a resin sheet layer having a flexural modulus of 1500 MPa or more and 4000 MPa or less.

The fifth resin sheet layer may be a film or sheet with a flexural modulus within the above range, and the type of the resin is not particularly limited. For example, it is possible to use a film or sheet of (meth)acrylic resins, polyvinyl chloride resins, polyvinylidene chloride resins, polycarbonate resins, acetal resins, polyester resins (polyethylene terephthalate, polybutylene terephthalate, and polyethylene naphthalate), polyamide resins, polyphenylene ether resins, and various other resins. These resin films or sheets may be stretched uniaxially or biaxially.

Of these resins, since electrical insulation, handling properties, and the like can be ensured, polyester resin is preferable. Further, the fifth resin sheet layer can be appropriately colored white, black, or the like. Examples of the coloring means include coating, film formation by pigment kneading, and the like.

For the film-forming method, T-die molding or inflation molding is used. Molding with a multilayer extruder is also possible.

The fifth resin sheet layer preferably has a flexural modulus of 1500 MPa or more and 4000 MPa or less, and more preferably 2000 MPa or more and 3500 MPa or less. If the flexural modulus is less than 1500 MPa, the required rigidity cannot be obtained. If the flexural modulus exceeds 4000 MPa, problems such that flexibility cannot be obtained, the adhesive for forming the adhesion layer described later has a poor coating property, or the sheet easily cracks are likely to occur.

The thickness of the fifth resin sheet layer is preferably 0.03 mm or more and 0.5 mm or less, and more preferably 0.05 mm or more and 0.3 mm or less. If the thickness of the fifth resin sheet layer is less than 0.03 the required rigidity may not be obtained. If the thickness of the fifth resin sheet layer exceeds 0.5 it is not possible to roll up the sheet and handling properties are likely to be reduced. The fifth resin sheet layer preferably has the same resin type or the same thickness as those of the second resin sheet layer in view of handling of the solar cell module.

### Weather-Resistant Layer

The surface opposite to the fourth resin layer of the fifth resin sheet layer may have another resin layer in view of weatherability.

The type of the resin is not particularly limited. For example, it is possible to use a film or sheet of polyolefin resins such as polyethylene resins (high density polyethylene, low density polyethylene, and linear low density polyethylene), polypropylene resins, and polybutene resins; (meth)acrylic resins; polyvinyl chloride resins; polystyrene resins; polyvinylidene chloride resins; ethylene-vinyl acetate copolymer saponified products; polyvinyl alcohols; polycarbonate resins; fluororesins (polyvinylidene fluoride, polyvinyl fluoride, and ethylene tetrafluoroethylene); polyvinyl acetate resins; acetal resins; polyester resins (polyethylene terephthalate, polybutylene terephthalate, and polyethylene naphthalate); polyamide resins; polyphenylene ether resins; and various other resins. These resin films or sheets may be stretched uniaxially or biaxially.

Of these resins, since electrical insulation, handling properties, and the like can be ensured in addition to weatherability, polyester resin is preferable. Further, the weather-resistant layer can be appropriately colored white, black, or the like by coating or film formation by pigment kneading, and the like.

For the film-forming method, T-die molding or inflation molding is used. Molding with a multilayer extruder is also possible.

### Adhesive Layer

The back protective layer may comprise an adhesive layer at at least one position selected from: between the first easy-adhesion resin layer and the second resin sheet layer, between the second resin sheet layer and the third resin layer, between the third resin layer and the fourth resin layer, between the fourth resin layer and the fifth resin sheet layer, and on one surface of the fifth resin sheet layer opposite to the surface on which the fourth resin layer is laminated.

The adhesive and the method for adhering the adhesive layer are not particularly limited. Examples include a known method according to dry lamination, coextrusion, and extrusion coating, all of which use a two-component curable urethane-based adhesive, polyether urethane-based adhesive, polyester-based adhesive, polyester polyol-based adhesive, polyester-polyurethane polyol-based adhesive, etc.; heat-lamination that uses an anchor coating agent; and the like.

When the first easy-adhesion resin layer and the second resin sheet layer are adhered, the adhesive layer preferably has a thickness of 3 µm or more and 30 µm or less, and particularly preferably 5 µm or more and 20 µm or less. When the adhesion between the second resin sheet layer and the third resin layer, the third resin layer and the fourth resin layer, and the fourth resin layer and the fifth resin sheet layer is performed, the adhesive layer preferably has a thickness of 20 µm or more and 200 µm or less, and particularly preferably 30 µm or more and 150 µm or less.

### Examples

The present invention is described in detail below with reference to Examples and Comparative Examples. However, the present invention is not limited to these Examples.

### Example 1

First, a white polyethylene (PE) film having a density of 1050 kg/m³, a tensile modulus of elasticity of 1000 MPa, and a thickness of 0.05 mm was prepared as a first easy-adhesion resin layer; a transparent polyethylene terephthalate (PET) film having a density of 1350 kg/m³, a flexural modulus of 2400 MPa, and a thickness of 0.125 mm was prepared as a second resin sheet layer; a foamed polypropylene (PP) sheet having a foaming ratio of 3-fold, a density of 400 kg/m³, a flexural modulus of 400 MPa, and a thickness of 3.0 mm was prepared as a third resin layer; and a glass cloth-reinforced polypropylene resin-based FRP (glass fiber density: 50 wt%) having a density of 1600 kg/m³, a flexural modulus of 20000 MPa, and a thickness of 0.5 mm was prepared as a fourth resin layer. These were bonded together with the following commercially available adhesives.

The first easy-adhesion resin layer and the second resin sheet layer were bonded with a urethane isocyanate-based adhesive for dry laminates (thickness: 10 µm).

The second resin sheet layer, the third resin layer, and the fourth resin layer were bonded with a urethane isocyanate-based adhesive for sheet coating (thickness: 70 µm). In this manner, a back protective layer was obtained. In accordance with a bending test (JIS K7171), the flexural modulus of the back protective layer was measured with the span between supports of 64 mm (calculated as the thickness of back protective layer 4 mm × 16). The measured flexural modulus was 551 MPa.

Second, tempered glass having a density of 2500 kg/m³, a flexural modulus of 60000 MPa, and a size of 1323 mm (length) × 990 mm (width) × 0.85 mm (thickness) was prepared as a surface glass layer; two EVAs (first sealing layer, second sealing layer) having the same dimension as the surface glass layer, and having a density of 960 kg/m³, a flexural modulus of 100 MPa, and a thickness of 0.5 mm were prepared as sealing layers; and 48 single-crystalline cells, each having a size of 156 mm × 156 mm × 200 µm (thickness), were prepared. Then, a commercially available interconnector (Hitachi Metals, Ltd.) and bus bar (Hitachi Metals, Ltd.) were attached to the cells.

The surface glass layer, the first sealing layer, the cells, the second sealing layer, and the back protective layer were placed in sequence on a hot plate of a vacuum laminator, and lamination was carried out at 140°C for 15 minutes. The cells were arranged in 6 rows in the lateral direction and 8 rows in the longitudinal direction, with respect to the surface glass layer. The laminate obtained after the vacuum lamination is referred to as a "panel." An aluminum frame with a height of 35 mm (aluminum frame weight: 2.4 kg per panel) was attached to the four sides of this panel with a silicon adhesive, thereby obtaining a solar cell module including the surface glass layer, the first sealing layer, the cells, the second sealing layer, and the back protective layer stacked in sequence.

This solar cell module had a size of 1633 mm in length and 990 mm in width, and was a 48-cell series module with a total thickness of 5.7 mm and a total weight including the aluminum frame of 12.0 kg/sheet (7.4 kg/m²).

A panel with no bubbles on the surface of the surface glass layer was classified as A, and a panel with bubbles was classified as B, by visual inspection.

When a panel placed on the floor had a height of 20 mm or more from the floor to the top of the square, the panel was determined to have warpage. A panel with no warpage was classified as A, and a panel with warpage was classified as B.

Subsequently, evaluation tests based on IEC61215 and JIS C8990 were performed on this solar cell module. An evaluation test was performed by subjecting the module to a DH test for 1000 hours, and inspecting the appearance. A module with no delamination between the sealing layer and the back protective layer was classified as A, and a module with delamination was classified as B.

Thereafter, the solar cell module was fixed to a metal rack along the four sides, and a load test was performed that included 3 cycles of a test of applying a uniformly distributed load alternately to the front side and back side of the module for 1 hour each. The test load was increased incrementally by 900 Pa from 2400 Pa, and the load at which no cracking occurred in the cells or the surface glass layer was recorded. A solar cell module that passed the test with a test load of 2400 Pa or more was classified as A according to the IEC standard. The following solar cell modules were classified as B: a solar cell module that failed the test with a test load of less than 2400 Pa, a solar cell module that had warpage, and a solar cell module that had delamination between the sealing layer and the back protective layer in the evaluation test, rendering the load test inoperable.

Example 1 passed (A) with a test load of 3600 Pa, and all other panel and module physical properties were also rated A. Table 1 below shows the conditions and the panel and module physical properties of the Examples and Comparative Examples. The test methods and evaluation criteria described in Example 1 were also applied in the same manner in other Examples and Comparative Examples.

### Example 2

A solar cell module was obtained in the same manner as in Example 1, except that a transparent polyethylene terephthalate (PET) film having a density of 1350 kg/m³, a flexural modulus of 2400 MPa, and a thickness of 0.125 mm as a fifth resin sheet layer, and a white polyethylene terephthalate (PET) film having a density of 1400 kg/m³, a flexural modulus of 2400 MPa, and a thickness 0.05 mm as a weather-resistant layer were bonded to the other surface of the fourth resin layer in sequence.

The fourth resin layer and the fifth resin sheet layer were bonded with an urethane isocyanate-based adhesive for sheet coating (thickness: 70 µm). The fifth resin sheet layer and the weather-resistant layer were bonded with a urethane isocyanate-based adhesive for dry laminates (thickness: 10 µm).

The flexural modulus of the back protective layer was 755 MPa. The total thickness was 5.9 mm. The total weight including the aluminum frame was 12.6 kg/sheet (7.8 kg/m²).

Example 2 passed (A) with a test load of 5400 Pa, and all other panel and module physical properties were also rated A.

### Example 3

A solar cell module was obtained in the same manner as in Example 2, except that the thickness of the surface glass layer was changed from 0.85 mm to 0.55 mm, the total thickness was set to 5.6 mm, and the total weight including the aluminum frame was set to 11.4 kg/sheet (7.0 kg/m²).

Example 3 passed (A) with a test load of 2400 Pa, and all other panel and module physical properties were also rated A.

### Example 4

A solar cell module was obtained in the same manner as in Example 2, except that the fourth resin layer was changed to a glass cloth-reinforced epoxy resin-based FRP (glass fiber density: 80 wt%) having a density of 2100 kg/m³, a flexural modulus of 30000 MPa, and a thickness of 0.5 mm (Table 1 shows the thickness of the fourth resin layer as 0.5-B); and that due to the change of the fourth resin layer, the flexural modulus of the back protective layer was set to 786 MPa, the panel thickness was set to 5.9 mm, and the total weight of the module including the aluminum frame was set to 13.0 kg/sheet (8.0 kg/m²).

Example 4 passed (A) with a test load of 5400 Pa, and all other panel and module physical properties were also rated A.

### Comparative Example 1

A solar cell module was obtained in the same manner as in Example 1, except that the first easy-adhesion resin layer and the second resin sheet layer were excluded, and that the third resin layer and the fourth resin layer were bonded to prepare a back protective layer. The flexural modulus of the back protective layer was 169 MPa. The total thickness was 5.4 mm. The total weight including the aluminum frame was 11.5 kg/sheet (7.1 kg/m²).

Comparative Example 1 had no panel warpage (A); however, it showed bubbles on the surface of the surface glass layer of the panel (B), and delamination between the sealing layer and the back protective layer in the evaluation test (B), which made the load test inoperable (B).

### Comparative Example 2

A solar cell module was obtained in the same manner as in Comparative Example 1, except that a white polyethylene (PE) film having a density of 1050 kg/m³, a tensile modulus of elasticity of 1000 MPa, and a thickness of 0.05 mm as a first easy-adhesion resin layer was bonded to the other surface of the third resin layer to prepare a back protective layer. The flexural modulus of the back protective layer was 171 MPa. The total thickness was 5.5 mm. The total weight including the aluminum frame was 11.7 kg/sheet (7.3 kg/m²).

Comparative Example 2 had no panel warpage (A) and no delamination between the sealing layer and the back protective layer in the evaluation test (A); however, it showed bubbles on the surface of the surface glass layer of the panel (B), and rated fail (B) with a test load of less than 2400 Pa in the load test.

### Comparative Example 3

A solar cell module was obtained in the same manner as in Comparative Example 1, except that a transparent polyethylene terephthalate (PET) film having a density of 1350 kg/m³, a flexural modulus of 2400 MPa, and a thickness of 0.125 mm as a fifth resin sheet layer, and a white polyethylene terephthalate (PET) film having a density of 1400 kg/m³, a flexural modulus of 2400 MPa, and a thickness of 0.05 mm as a weather-resistant layer were bonded to the other surface of the fourth resin layer. The flexural modulus of the back protective layer was 221 MPa. The total thickness was 5.7 mm. The total weight including the aluminum frame was 12.0 kg/sheet (7.5 kg/m²).

Comparative Example 3 had no panel warpage (A); however, it showed bubbles on the surface of the surface glass layer of the panel (B), and delamination between the sealing layer and the back protective layer in the evaluation test (B), which made the load test inoperable (B).

### Comparative Example 4

A solar cell module was obtained in the same manner as in Example 2, except that the fourth resin layer was excluded, and two foamed polypropylene (PP) sheets having a foaming ratio of 3-fold, a density of 400 kg/m³, a flexural modulus of 400 MPa, and a thickness of 2.0 mm were bonded to prepare a third resin layer having a thickness of 4.0 mm, thereby obtaining a back protective layer. The flexural modulus of the back protective layer was 695 MPa. The total thickness was 6.4 mm. The total weight including the aluminum frame was 11.9 kg/sheet (7.4 kg/m²).

Comparative Example 4 had no bubbles on the surface of the surface glass layer of the panel (A); however, it showed panel warpage (B). Because the warpage was excessively large, the aluminum frame could not be attached, and the evaluation test and load test were inoperable (B).

**Table 1**

| | Thickness (mm) | | | | | | | Flexural Modulus of Back Protective Layer (MPa) | Total Weight of Module [kg/ sheet] (kg/m²) | Panel and Module Physical Properties | | | |
|---|---|---|---|---|---|---|---|---|---|---|---|---|---|
| | Surface Glass Layer | First Easy-adhesion Resin Layer | Second Resin Sheet Layer | Third Resin Layer | Fourth Resin Layer | Fifth Resin Sheet Layer | Weather-resistant Layer | | | Bubbles Remained on Panel | Panel Warpage | Delamination after DH Test | Test Load after DH Test (Pa) |
| Ex. 1 | 0.85 | 0.05 | 0.125 | 3.0 | 0.5 | - | - | 551 | [12.0] (7.4) | None A | None A | None A | 3600 A |
| Ex. 2 | 0.85 | 0.05 | 0.125 | 3.0 | 0.5 | 0.125 | 0.05 | 755 | [12.6] (7.8) | None A | None A | None A | 5400 A |
| Ex. 3 | 0.55 | 0.05 | 0.125 | 3.0 | 0.5 | 0.125 | 0.05 | 755 | [11.4] (7.0) | None A | None A | None A | 2400 A |
| Ex. 4 | 0.85 | 0.05 | 0.125 | 3.0 | 0.5-B | 0.125 | 0.05 | 786 | [13.0] (8.0) | None A | None A | None A | 5400 A |
| Com. Ex. 1 | 0.85 | - | - | 3.0 | 0.5 | - | - | 169 | [11.5] (7.1) | Observed B | None A | Observed B | Inoperable B |
| Com. Ex. 2 | 0.85 | 0.05 | - | 3.0 | 0.5 | - | - | 171 | [11.7] (7.3) | Observed B | None A | None A | Less Than 2400 B |
| Com. Ex. 3 | 0.85 | - | - | 3.0 | 0.5 | 0.125 | 0.05 | 221 | [12.0] (7.5) | Observed B | None A | Observed B | Inoperable B |
| Com. Ex. 4 | 0.85 | 0.05 | 0.125 | 4.0 | - | 0.125 | 0.05 | 695 | [11.9] (7.4) | None A | Observed B | Inoperable B | Inoperable B |

The results above revealed that the solar cell modules including, in sequence from the light-receiving surface side, a glass layer having a thickness of 0.4 mm or more and 1.6 mm or less, a first sealing layer, cells, a second sealing layer, and a back protective layer, wherein the back protective layer includes, in sequence from the side closer to the second sealing layer, a first easy-adhesion resin layer having adhesiveness to the second sealing layer, a second resin sheet layer having a flexural modulus of 1500 MPa or more and 4000 MPa or less, a third resin layer in a foam state and having a flexural modulus of 200 MPa or more and 1000 MPa or less, and a fiber-reinforced fourth resin layer having a flexural modulus of 10000 MPa or more and 45000 MPa or less had no remaining bubbles on the surface of the surface glass layer after vacuum lamination and delamination between the second sealing layer and the back protective layer after DH; and were light yet had load-bearing properties sufficient to prevent the cells from cracking even under a load of above 2400 Pa. The results also revealed that adding a fifth resin sheet layer having a flexural modulus of 1500 MPa or more and 4000 MPa or less under the fourth resin layer further increases the flexural modulus and load-bearing properties.

### Description of the Reference Numerals

- 10:: Surface glass layer
- 20:: First sealing layer
- 30:: Cell
- 40:: Second sealing layer
- 50:: Back protective layer
- 51:: First easy-adhesion resin layer
- 52:: Second resin sheet layer
- 53:: Third resin layer
- 54:: Fourth resin layer
- 55:: Fifth resin sheet layer

## Claims

1. A solar cell module comprising, in sequence from a light-receiving surface side, a surface glass layer having a thickness of 0.4 mm or more and 1.6 mm or less, a first sealing layer, cells, a second sealing layer, and a back protective layer,
wherein
the back protective layer comprises, in sequence from a side closer to the second sealing layer,
a first easy-adhesion resin layer having adhesiveness to the second sealing layer,
a second resin sheet layer having a flexural modulus of 1500 MPa or more and 4000 MPa or less,
a third resin layer being in a foam state and having a flexural modulus of 200 MPa or more and 1000 MPa or less, and
a fiber-reinforced fourth resin layer having a flexural modulus of 10000 MPa or more and 45000 MPa or less.

2. The solar cell module according to claim 1, further comprising a fifth resin sheet layer having a flexural modulus of 1500 MPa or more and 4000 MPa or less on one surface side of the fourth resin layer, the surface side being opposite to a surface side on which the third resin layer is positioned.

3. The solar cell module according to claim 1 or 2, wherein the first easy-adhesion resin layer comprises one or more resins selected from the group consisting of polyethylene resins, polypropylene resins, polystyrene resins, polyurethane resins, polybutene resins, polymethyl methacrylate resins, polyvinyl chloride resins, polyvinyl acetate resins, and polyvinyl alcohol resins, or a copolymer containing the one or more resins.

4. The solar cell module according to any one of claims 1 to 3, wherein the second resin sheet layer comprises one or more resins selected from the group consisting of polyvinyl chloride resins, polycarbonate resins, polymethyl methacrylate resins, polyethylene terephthalate resins, polybutylene terephthalate resins, polyethylene naphthalate resins, polyacetal resins, polyamide resins, and polyphenylene ether resins.

5. The solar cell module according to any one of claims 1 to 4, wherein the third resin layer comprises a foam body of one or more resins selected from the group consisting of polyethylene resins, polypropylene resins, polyamide resins, polystyrene resins, polyurethane resins, polyvinyl chloride resins, polycarbonate resins, polymethyl methacrylate resins, polyethylene terephthalate resins, polybutylene terephthalate resins, acrylonitrile styrene resins, acrylonitrile butadiene styrene resins, polyacetal resins, polyphenylene sulfide resins, polyethersulfone resins, polyether ether ketone resins, epoxy resins, vinyl ester resins, polyimide resins, unsaturated polyester resins, phenol resins, urea resins, melamine resins, and fluororesins.

6. The solar cell module according to any of claims 1 to 5, wherein the fourth resin layer comprises a fiber-reinforced resin in which glass fiber is mixed with one or more resins selected from the group consisting of polyethylene resins, polypropylene resins, polyamide resins, polystyrene resins, polyurethane resins, polyvinyl chloride resins, polycarbonate resins, polymethyl methacrylate resins, polyethylene terephthalate resins, polybutylene terephthalate resins, acrylonitrile styrene resins, acrylonitrile butadiene styrene resins, polyacetal resins, polyphenylene sulfide resins, polyethersulfone resins, polyether ether ketone resins, epoxy resins, vinyl ester resins, polyimide resins, unsaturated polyester resins, phenol resins, urea resins, melamine resins, and fluororesins.

7. The solar cell module according to any one of claims 1 to 6, wherein the third resin layer has a thickness of 2 mm or more and 6 mm or less, and a density of 100 kg/m³ or more and 700 kg/m³ or less.

8. The solar cell module according to claim 6 or 7, wherein the fourth resin layer has a thickness of 0.5 mm or more and 2.0 mm or less, and a glass fiber content of 30 wt% or more and 70 wt% or less.
